# EUROPEAN PATENT SPECIFICATION

(11) **EP 2 866 267 B1**
(45) Date of publication and mention of the grant of the patent: **04.04.2018**
(21) Application number: 13810692.7
(22) Date of filing: 26.06.2013
(51) Int. Cl.: H01L 31/048, B32B 27/32, C09D 123/08, C09D 151/06

(54) **SOLAR-CELL-SEALING SHEET, SOLAR CELL MODULE, AND METHOD FOR MANUFACTURING SAME**
ABDICHTUNGSFOLIE FÜR SOLARZELLEN, SOLARZELLENMODUL UND VERFAHREN ZUR HERSTELLUNG DAVON
FEUILLE D'ÉTANCHÉITÉ DE CELLULE SOLAIRE, MODULE DE CELLULE SOLAIRE ET PROCÉDÉ DE FABRICATION DE CE DERNIER

(30) Priority: 26.06.2012 JP 2012143257
(43) Date of publication of application: 29.04.2015
(73) Proprietor: Mitsui Chemicals Tohcello, Inc., Tokyo 101-8485 (JP)
(72) Inventor: TANABE, Masaru, Nagoya-shi, Aichi 457-0801 (JP); SHIMIZU, Katsuhiko, Nagoya-shi, Aichi 457-0801 (JP); TOKUHIRO, Jun, Hitachinaka-shi, Ibaraki 312-0002 (JP)
(74) Representative: Hoffmann Eitle
(86) International application number: PCT/JP2013/067480
(87) International publication number: WO 2014/003046

(56) References cited:
- EP-A2- 2 043 163
- WO-A1-2011/152314
- JP-A- 2005 050 928
- JP-A- 2005 050 928
- JP-A- 2006 210 405
- JP-A- 2006 210 405

## Description

### TECHNICAL FIELD

The present invention relates to a solar battery-sealing sheet, a solar battery module and a method for manufacturing the same.

### BACKGROUND ART

In order to improve the electricity generating efficiency of solar batteries, incident light is conventionally required to be condensed on solar electricity generating elements for solar batteries as efficiently as possible. Therefore, a sealant of the light-receiving side (front surface side) is desirably one having a transparency as high as possible and transmitting incident light without absorbing or reflecting the light.

On the other hand, as a sealant of the backside (opposite side of the light-receiving surface), sealing materials to enhance the utilization efficiency of light have been developed (for example, Patent Documents 1 to 3). In these sealing materials, a white colorant such as titanium dioxide is blended so that light passed between a plurality of elements for a solar battery and light transmitted through the elements for the solar battery are made to be reflected by the light reflection at the interface between the back surface and the light-receiving surface and the light diffuse reflection due to the colorant.

Generally, solar battery modules are manufactured by deaerating under reduced pressure a laminate obtained by laminating a light-receiving side-transparent protection member, a light-receiving side-sealant, solar battery cells, a backside-sealant and a backside-protection member (back sheet) in this order, and heating and pressing the laminate to thereby adhering and unifying the laminate. In this process, the melted backside-sealant flows and comes around the light-receiving side from the side surfaces of the laminate and the gaps between solar battery cells to intrude between the solar battery cells and the light-receiving side-sealant in some cases. Particularly in some cases where the backside-sealant is composed of a colored material, the coming-around of the backside-sealant causes a decrease in the electricity generating efficiency and the faulty appearance. Further in the lamination step of adhering and unifying the laminate, the overspill of the backside-sealant from a frame pollutes a lamination apparatus in some cases.

Patent Document 1 proposes a sealing film having a melt flow rate of 14 g/10 min or lower. Patent Document 2 proposes a solar battery in which the vinyl acetate content of an ethylene-vinyl acetate copolymer (EVA) of a transparent light-receiving side-sealing film is higher than the vinyl acetate content of EVA of a colored backside-sealing film. Patent Document 3 proposes a solar battery in which the melt flow rate of EVA of a transparent light-receiving side-sealing film is higher than the melt flow rate of EVA of a colored backside-sealing film. Patent Document 4 proposes further providing a transparent sealant layer between solar battery cells and a colored backside-sealant to prevent the coming-around of the colored backside-sealant.

The methods stated in Patent Documents 1 to 3, however, cannot prevent the above-mentioned phenomenon depending on the heating and pressing condition in the manufacturing process in some cases. The method stated in Patent Document 4 needs to provide two layers of a transparent layer and a colored layer as the backside-sealant to resultantly bring about a manufacture load increase and a cost increase.

EP 2 043 163 A2 describes a method of manufacturing a solar cell module comprising a first and a second sealing member. The second sealing member is arranged to form a surface including a plurality of convex portions facing the first sealing member. The method comprises the heating of the first sealing member to a temperature equal to or higher than its melting point but lower than the melting point of the second sealing member and pressing the protrusions of second sealing member into the first sealing member. In an example, the melting point of the first sealing member is 76°C and the second sealing member does not contain a colorant.

WO 2011/152314 A1 describes a sealing material for solar cell modules and a manufacturing method thereof using a polyethylene resin. The polyethylene resin has a density of 0.900 g/cm³ or less, and an MFR between 0.1g/10min and 1.0g/10min.

In JP 2006-210405 A, a solar battery module is described. The solar battery module has a transparent front substrate, the surface filling layer, the solar battery element in which a wiring electrode and a demountable electrode are arranged, and the back filling layer containing a silane-modified polyethylene resin. The melting point of the back filling layer is higher than that of the surface filling layer.

### PRIOR ART DOCUMENTS

### PATENT DOCUMENTS

Patent Document 1: JP06-177412A
Patent Document 2: JP2003-258283A
Patent Document 3: JP2005-050928A
Patent Document 4: JP2011-216804A

### SUMMARY OF THE INVENTION

### PROBLEMS TO BE SOLVED BY THE INVENTION

The present invention has been made in consideration of the above-mentioned problems, and has an object to provide a solar battery-sealing sheet reduced in the coming-around of a backside-sealant, and a solar battery module using the sealing sheet and a method for manufacturing the solar battery module.

### MEANS FOR SOLVING PROBLEMS

The present invention is a pair of solar battery-sealing sheets including a light-receiving side-sealing sheet and a backside-sealing sheet for a solar electricity generating element of a solar battery module, wherein a melt peak temperature based on a differential scanning calorimetry (DSC) of the backside-sealing sheet is higher than a melt peak temperature based on the differential scanning calorimetry (DSC) of the light-receiving side-sealing sheet. The melt peak temperature based on DSC of the light-receiving side-sealing sheet is 75°C or lower, or in a range of substantially no peak observed, and the melt peak temperature based on DSC of the backside-sealing sheet is 90°C or higher. Furthermore, the backside-sealing sheet comprises: an ethylene-based polymer obtained by modifying an ethylene·α-olefin copolymer having a density of 900 to 940 kg/m³ as measured in conformity to ASTM D1505 and a melt peak temperature based on DSC of 90 to 125°C with an ethylenic unsaturated silane compound; and a colorant.

Further, the present invention is a solar battery module, being obtained by laminating a light-receiving side-protection member, a light-receiving side-sealing sheet, a solar electricity generating element, a backside-sealing sheet and a backside-protection member in this order, wherein the light-receiving side-sealing sheet and the backside-sealing sheet are a light-receiving side-sealing sheet and a backside-sealing sheet of the pair of solar battery-sealing sheets according to the present invention, respectively.

In addition, the present invention is also a method for manufacturing a solar battery module, including a step of stacking a light-receiving side-protection member, a light-receiving side-sealing sheet, a solar electricity generating element, a backside-sealing sheet and a backside-protection member in this order, and thermally pressure-bonding the resultant to thereby obtain a laminate, wherein the light-receiving side-sealing sheet and the backside-sealing sheet are a light-receiving side-sealing sheet and a backside-sealing sheet of the pair of solar battery-sealing sheets according to the present invention, respectively.

### EFFECTS OF THE INVENTION

According to the present inventive pair of solar battery-sealing sheets used for the light-receiving side and the backside, since the backside-sealing sheet more hardly melts and flows than the light-receiving side-sealing sheet during the lamination, the coming-around during the lamination can be avoided, and the decrease of the electricity generating efficiency and the faulty appearance can resultantly be prevented.

The solar battery module according to the present invention is a solar battery module prevented from such a decrease of the electricity generating efficiency and such faulty appearance. In addition, the method for manufacturing a solar battery module according to the present invention is a method capable of manufacturing such an excellent solar battery module simply and efficiently.

### MODES FOR CARRYING OUT THE INVENTION

The solar battery-sealing sheet according to the present invention is a pair of sealing sheets composed of a sealing sheet used for the light-receiving side of solar electricity generating elements (light-receiving side-sealing sheet) and a sealing sheet used for the backside (backside-sealing sheet). The melt peak temperature based on a differential scanning calorimetry (DSC) of the backside-sealing sheet is higher than the melt peak temperature based on DSC of the light-receiving side-sealing sheet. The backside-sealing sheet is thereby made to more hardly melt and flow than the light-receiving side-sealing sheet during the lamination.

The melt peak temperature based on DSC of the light-receiving side-sealing sheet is 75°C or lower, or in the range of substantially no peak observed. The melt peak temperature based on DSC of the backside-sealing sheet is 90°C or higher, preferably 90°C to 125°C, and more preferably 90°C to 115°C. The melt peak temperature based on DSC used here is a temperature of the summit of the melt peak in an endothermic curve determined by a differential scanning calorimetry under a condition described in Examples described later. In the case where a plurality of peaks is detected, a peak detected on the highest temperature side is defined as the melt peak temperature.

A resin component constituting the light-receiving side-sealing sheet is not especially limited, and suffices if satisfying the above-mentioned relationship of the melt peak temperature. For example, an ethylene-based polymer such as an ethylene homopolymer and a copolymer of ethylene and another monomer (for example, α-olefin or vinyl acetate) can be used. Particularly preferable are:
1) an ethylene-based polymer having a density of 860 or higher and lower than 900 kg/m³ as measured in conformity to ASTM D1505 and a melt peak temperature based on DSC of lower than 90°C; and
2) an ethylene-vinyl acetate copolymer having a vinyl acetate content of 10 to 47% by mass, and a melt peak temperature based on DSC of lower than 90°C.

The ethylene-based polymer of the above 1) is preferably an ethylene·α-olefin copolymer further satisfying any or all of the following requirements a1) to a4):
a1) The proportion of a constituting unit derived from ethylene is 80 to 90 mol%, and the proportion of a constituting unit derived from α-olefins having 3 to 20 carbon atoms (for example, propylene, butene and pentene) is 10 to 20 mol%.
a2) The melt flow rate (MFR) measured in conformity to ASTM D1238 under the condition of 190°C and a load of 2.16 kg is 10 to 50 g/10 min.
a3) The density measured in conformity to ASTM D1505 is 0.865 to 0.884 g/cm³.
a4) The shore A hardness measured in conformity to ASTM D2240 is 60 to 85.

An ethylene·α-olefin copolymer satisfying the above requirement a2) can be molded into a light-receiving side-sealing sheet, for example, by extrusion.

Even in the case of not satisfying the above requirement a2), that is, the case where MFR is out of the range of 10 to 50 g/10 min, a preferable ethylene·α-olefin copolymer exists. For example, an ethylene·α-olefin copolymer satisfying the following requirement a2') is also preferable. a2') The melt flow rate (MFR) measured in conformity to ASTM D1238 under the condition of 190°C and a load of 2.16 kg is 1 g/10 min or higher and lower than 10 g/10 min (preferably 2 g/10 min or higher and lower than 10 g/10 min).

An ethylene·α-olefin copolymer satisfying the above requirement a2') can be molded into a light-receiving side-sealing sheet, for example, by calendar molding. If MFR is lower than 10 g/10 min, the ethylene·α-olefin copolymer is preferable in the point that in the lamination, it can avoid the pollution of the lamination apparatus due to the overspill of the backside-sealant.

The vinyl acetate content of the ethylene-vinyl acetate copolymer of the above requirement 2) is more preferably 20 to 35% by mass. The MFR of the ethylene-vinyl acetate copolymer as measured in conformity to ASTM D1238 under the condition of 190°C and a 2.16-kg load is preferably 10 to 35 g/10 min, and more preferably 10 to 25 g/10 min. If the MFR is in the above range, the ethylene-vinyl acetate copolymer can be molded into a light-receiving side-sealing sheet by extrusion.

In the case of being molded into a light-receiving side-sealing sheet by calendar molding, the MFR of the ethylene-vinyl acetate copolymer is preferably 1 g/10 min or higher and lower than 10 g/10 min, and more preferably 2 g/10 min or higher and lower than 10 g/10 min. If the MFR is lower than 10 g/10 min, the ethylene-vinyl acetate copolymer is preferable in the point that in the lamination, it can avoid the pollution of the lamination apparatus due to the overspill of the backside-sealant.

The backside-sealing sheet comprises an ethylene-based polymer obtained by modifying an ethylene·α-olefin copolymer with an ethylenic unsaturated silane compound. The ethylene-based polymer is obtained by modifying an ethylene·α-olefin copolymer having a density of 900 to 940 kg/m³ as measured in conformity to ASTM D1505 and a melt peak temperature based on DSC of 90 to 125°C with an ethylenic unsaturated silane compound.

This ethylene·α-olefin copolymer includes a copolymer having a proportion of a constituting unit derived from ethylene of 90 to 98 mol% and a proportion of a constituting unit derived from an α-olefin of 2 to 10 mol%. Such an ethylene·α-olefin copolymer can be obtained, for example, by the polymerization using a Ziegler catalyst or a metallocene catalyst. Examples of the α-olefin include α-olefins having 3 to 20 carbon atoms such as propylene, butene and pentene.

An ethylenic unsaturated silane compound modifying the ethylene·α-olefin copolymer is not especially limited, and a conventionally known one can be used. Specific examples thereof include vinyltriethoxysilane, vinyltrimethoxysilane, vinyltris(β-methoxyethoxysilane), γ-glycidoxypropyltrimethoxysilane, γ-aminopropyltriethoxysilane and γ-methacryloxypropyltrimethoxysilane. Particularly from the point of the adhesivity, γ-glycidoxypropylmethoxysilane, γ-aminopropyltriethoxysilane, γ-methacryloxypropyltrimethoxysilane and vinyltriethoxysilane are preferable.

The backside-sealing sheet contains a colorant. The colorant is an inorganic or organic fine particle, and is blended for coloring, for example, to white, black, blue or red. A white colorant such as calcium carbonate or titanium dioxide is used to reflect incident light and enhance the light utilization efficiency. Magnesium hydroxide, which is similarly white, can be blended also as a flame retardant. A black colorant such as carbon black may be used to enhance the designability of panels. Besides, ultra marine blue and ultra marine red can also be used. Among these, preferable is a white colorant selected from the group consisting of calcium carbonate, barium sulfate, zinc oxide and titanium dioxide, and especially preferable is titanium dioxide. The blend amount of the colorant is, with respect to 100 parts by mass of a polymer being the resin component, preferably 0.1 to 10 parts by mass, and more preferably 0.1 to 5 parts by mass.

The light-receiving side-sealing sheet and the backside-sealing sheet in the present invention can be obtained by molding the resin component or the resin composition including the resin component and other components described above into a sheet form. Each component may be mixed as it is. However, since the case of the backside-sealing sheet contains a colorant, from the point of homogeneously dispersing the colorant, a method is preferable in which a master batch (MB) composed of a resin component and the colorant is first prepared, and the MB is then blended in the resin component. The concentration of the colorant in the MB and the blend amount of the MB are not especially limited. Usually, the concentration of the colorant in the MB is preferably 20 to 60% by mass. For example, in the case where the concentration of the colorant in the MB is 50% by mass, the blend amount of the MB with respect to 100 parts by mass of a polymer is preferably 5 to 20 parts by mass. This resin composition is processed by extrusion or calendar molding, particularly extrusion, as described later, to thereby obtain a resin sheet.

The sealing sheet according to the present invention may contain, in addition to the respective components described above, additives such as a crosslinking agent, a crosslinking aid, an adhesion promoter, an ultraviolet absorber, a light stabilizer and an antioxidant as needed.

Specific examples of the crosslinking agents include organic peroxides such as 2,5-dimethyl-2,5-bis(t-butyl peroxy)hexane, t-butyl-peroxy2-ethylhexyl carbonate, 1,1-di(t-butyl peroxy)cyclohexane and t-butyl-peroxy2-ethyl hexanoate. The blend amount of the crosslinking agent is, with respect to 100 parts by mass of a polymer being the resin component, preferably 0.1 to 1.6 parts by mass, and more preferably 0.6 to 0.8 parts by mass.

Specific examples of the crosslinking aids include allyl group-containing compounds such as triallyl isocyanurate and triallyl cyanurate. The blend amount of the crosslinking aid is preferably 10 parts by mass or less with respect to 100 parts by mass of the polymer.

Specific examples of the adhesion promoter include vinyltriethoxysilane, vinyltrichlorosilane, vinyltris(β-methoxy-ethoxy)silane, β-(3,4-epoxycyclohexyl)-ethyltrimethoxysilane, γ-glycidoxypropyl-trimethoxysilane and γ-aminopropyltriethoxysilane. The blend amount of the adhesion promoter is preferably 5 parts by mass or less with respect to 100 parts by mass of the polymer.

Specific examples of the ultraviolet absorbers include benzophenone-based compounds such as 2-hydroxy-4-methoxybenzophenone, 2,2-dihydroxy-4-methoxybenzophenone, 2-hydroxy-4-methoxy-2-carboxybenzophenone and 2-hydroxy-4-n-octoxybenzophenone; benzotriazole-based compounds such as 2-(2-hydroxy-3,5-ditertiarybutylphenyl)benzotriazole, 2-(2-hydroxy-5-methylphenyl)-benzotriazole and 2-(2-hydroxy-5-tertiaryoctylphenyl)benzotriazole; and salicylic ester-based compounds such as phenyl salicylate and p-octylphenyl salicylate. Specific examples of the light stabilizer include hindered amine-based compounds. Specific examples of the antioxidant include hindered phenol-based compounds and phosphite-based compounds. The ultraviolet absorber, the light stabilizer and the antioxidant may be used in amounts within the range of not spoiling the object and the advantage of the present invention.

The thicknesses of the light-receiving side-sealing sheet and the backside-sealing sheet according to the present invention are preferably 100 µm to 2.0 mm.

A method for manufacturing the solar battery-sealing sheet is not especially limited. For example, a resin material can process into a sheet form by extrusion, calendar molding or the like to obtain a resin sheet. Here, since the case of the backside-sealing sheet usually contains a colorant, a method is especially preferable in which a resin composition containing a master batch as described before is melted and kneaded, and extruded. The light-receiving side-sealing sheet usually contains no colorant because of being required to have transparency.

The solar battery module according to the present invention is obtained by laminating a light-receiving side-protection member (front side-transparent protection member or the like), a light-receiving side-sealing sheet (the light-receiving side-sealing sheet of the solar battery-sealing sheet according to the present invention), solar electricity generating elements, a backside-sealing sheet (the backside-sealing sheet of the solar battery-sealing sheet according to the present invention) and a backside-protection member (back sheet) in this order.

As the light-receiving side-protection member, a glass material is usually used from the point of the durability and the transparency. As the backside-protection member, a resin sheet or a glass material is used, but particularly a polyethylene terephthalate (PET)-based resin sheet is preferable.

The solar battery module can be manufactured by a process of stacking the light-receiving side-protection member (front side-transparent protection member or the like), the light-receiving side-sealing sheet (the light-receiving side-sealing sheet of the solar battery-sealing sheet according to the present invention), solar electricity generating elements, the backside-sealing sheet (the backside-sealing sheet of the solar battery-sealing sheet according to the present invention) and a backside-protection member (back sheet) in this order, and heating and compression bonding the resultant to thereby obtain a laminate. The specific manufacture condition is not especially limited, and may be according to a well-known method. The temperature of the heating and compression bonding is preferably 120 to 170°C. In the heating, it is preferable that the resultant be first held under vacuum for a certain time, and thereafter pressed to be laminated.

### EXAMPLES

Hereinafter, the present invention will be described in more detail by way of Examples. In the following description, "parts" means "parts by mass" and "%" means "% by mass" unless otherwise specified. Each physical property of a polymer was measured by the following method.

### (1) Melt peak temperature:

A differential scanning calorimeter (made by PerkinElmer Japan Co., Ltd., trade name: DSC8000) was used. A specimen of about 5 mg was heated at 320°C/min from 0°C to 200°C, held at 200°C for 5 min, cooled at 10°C/min from 200°C to 0°C, and further held at 0°C for 5 min. Then an endothermic curve was determined while the specimen was heated at 10°C/min. The summit of a melt peak therein was defined as a melt peak temperature. Here, in the case where a plurality of peaks was detected, a peak detected on the highest temperature side was defined as a melt peak temperature.

### (2) Density:

The density was measured in conformity to ASTM D1505.

### (3) Melt flow rate (MFR):

MFR was measured in conformity to ASTM D1238 under the condition of 190°C and a 2.16-kg load.

### (4) Shore A hardness:

The Shore A hardness was measured in conformity to ASTM D2240.

### <Synthesis Example 1: synthesis of an ethylene-based polymer (PE-1)>

A prepolymerization catalyst composed of 1-hexene and ethylene was obtained using dimethylsilylenebis(3-methylcyclopentadienyl)zirconium dichloride being a metallocene catalyst by a method described in JP 2011-12243A.

Separately therefrom, 830 mL of dehydration-refined hexane was put in a 2-litter stainless steel autoclave sufficiently replaced inner space by nitrogen; and the inner space was replaced by a mixed gas (hydrogen content of 0.7 mol%) of ethylene and hydrogen. The inner system was then made to be at 60°C; and 1.5 mmol of triisobutylaluminum, 179 mL of 1-hexene, and the prepolymerization catalyst prepared above in an amount of 0.015 mg atom in terms of zirconium atom were then added.

Thereafter, a mixed gas, having the same composition as above, of ethylene and hydrogen was introduced; and the polymerization was initiated under a total pressure of 3 MPaG. The mixed gas only was further introduced to hold the total pressure at 3 MPaG, and the polymerization was carried out at 70°C for 1.5 hours. After the completion of the polymerization, thus obtained polymer was filtered, and dried at 80°C for one night to thereby obtain 105 g of a powdery ethylene-based polymer (PE-1). The density of the ethylene-based polymer (PE-1) was 910 kg/m³; the melt peak temperature, 109°C; and the MFR, 10 g/10 min (190°C).

### <Example 1>

### (Manufacture of a light-receiving side-sealing sheet)

100 parts of an ethylene·vinyl acetate copolymer (vinyl acetate content: 28%, melt peak temperature: 71 °C, MFR: 15 g/10 min (190°C)) was blended with 0.1 part of 2,5-dimethyl-2,5-bis(t-butyl peroxy)hexane, 0.4 part of t-butyl peroxy-2-ethylhexyl carbonate and 1.0 part of triallyl isocyanurate to obtain a resin composition. The resin composition was extruded by a T-die extruder to mold a resin sheet (light-receiving side-sealing sheet) of about 450 µm in thickness.

### (Manufacture of a backside-sealing sheet)

100 parts of the ethylene-based polymer (PE-1) obtained in Synthesis Example 1 was blended with 1.0 part of vinyltrimethoxysilane, 0.02 part of 2,5-dimethyl-2,5-di(t-butyl peroxy)hexane and 6 parts of a master batch containing titanium dioxide as a colorant (titanium dioxide concentration: 50%) to thereby obtain a resin composition. The resin composition was extruded by a T-die extruder to thereby mold a resin sheet (backside-sealing sheet) of about 450 µm in thickness.

### (Fabrication of a solar battery module)

By using the above each sealing sheet, a glass of 3.2 mm in thickness, the light-receiving side-sealing sheet, solar battery cells, the backside-sealing sheet, and a PET-based back sheet (backside-protection member) were stacked in this order, and laminated using a vacuum laminator under the condition of 165°C, a vacuum for 5 min and a pressing for 15 min to thereby fabricate a solar battery module. Whether or not the backside-sealing sheet of the solar battery module came around on light-receiving surfaces or bus-bar electrodes of the solar battery cells was visually checked through the glass by checking the coming-around of the colorant, and no coming-around was observed at all.

### <Example 2>

### (Manufacture of a light-receiving side-sealing sheet)

A light-receiving side-sealing sheet of about 450 µm in thickness was molded as in Example 1, except for using a resin composition obtained by blending 100 parts of an ethylene·butene copolymer (made by Mitsui Chemicals Inc., trade name: Tafmer A4085, melt peak temperature: 72°C, MFR: 3.6 g/10 min (190°C), density: 885 kg/m³, Shore A hardness: 84) with 1 part of t-butyl peroxy-2-ethylhexyl carbonate and 1 part of triallyl isocyanurate.

### (Manufacture of a backside-sealing sheet)

A backside-sealing sheet of about 450 µm in thickness was molded as in Example 1.

### (Fabrication of a solar battery module)

A solar battery module was fabricated as in Example 1 by using the above each sealing sheet. The solar battery module was visually checked through the glass, and no coming-around of the colorant was observed at all.

### <Example 3>

### (Manufacture of a light-receiving side-sealing sheet)

A light-receiving side-sealing sheet of about 450 µm in thickness was molded as in Example 1, except for using a resin composition obtained by blending 100 parts of an ethylene·propylene copolymer (made by Mitsui Chemicals Inc., trade name: Tafmer P0275, melt peak temperature: 30°C, MFR: 2.5 g/10 min (190°C), density: 875 kg/m³, Shore A hardness: 56) with 1 part of t-butyl peroxy-2-ethylhexyl carbonate and 1 part of triallyl isocyanurate.

### (Manufacture of a backside-sealing sheet)

A backside-sealing sheet of about 450 µm in thickness was molded as in Example 1.

### (Fabrication of a solar battery module)

A solar battery module was fabricated as in Example 1 by using the above each sealing sheet. The solar battery module was visually checked through the glass, and no coming-around of the colorant was observed at all.

### <Comparative Example 1 >

### (Manufacture of a light-receiving side-sealing sheet)

A light-receiving side-sealing sheet of about 450 µm in thickness was molded as in Example 1.

### (Manufacture of a backside-sealing sheet)

A backside-sealing sheet of about 450 µm in thickness was molded as in Example 1, except for using a resin composition obtained by blending 100 parts of an ethylene·vinyl acetate copolymer (vinyl acetate content: 28%, melt peak temperature: 71°C, MFR: 15 g/10 min (190°C)) with 1.5 parts of 2,5-dimethyl-2,5-bis(t-butyl peroxy)hexane and 1.0 part of triallyl isocyanurate, and 6 parts of a master batch containing titanium dioxide as a colorant (titanium dioxide concentration: 50%).

### (Fabrication of a solar battery module)

A solar battery module was fabricated as in Example 1 by using the above each sealing sheet. The solar battery module was visually checked through the glass, and it was observed that the colorant came around on the light-receiving surface and bus-bar electrodes of the solar battery cells.

### <Comparative Example 2>

### (Manufacture of a light-receiving side-sealing sheet)

A light-receiving side-sealing sheet of about 450 µm in thickness was molded as in Example 2.

### (Manufacture of a backside-sealing sheet)

A backside-sealing sheet of about 450 µm in thickness was molded as in Comparative Example 1.

### (Fabrication of a solar battery module)

A solar battery module was fabricated as in Example 1 by using the above each sealing sheet. The solar battery module was visually checked through the glass, and it was observed that the colorant came around on the light-receiving surface and bus-bar electrodes of the solar battery cells.

It is clear from the results of Examples 1 to 3 and Comparative Examples 1 and 2 as described above that the use of a resin sheet as a backside-sealing sheet, which has a high melt peak temperature and hardly melts and flows, can prevent the coming-around of the backside-sealing sheet containing a colorant on the front of the solar battery cells. Therefore, the present invention can well manufacture a solar battery module without reducing its properties.

## Claims

1. A pair of solar battery-sealing sheets comprising a light-receiving side-sealing sheet and a backside-sealing sheet for a solar electricity generating element of a solar battery module,
wherein a melt peak temperature based on a differential scanning calorimetry (DSC) of the backside-sealing sheet is higher than a melt peak temperature based on the differential scanning calorimetry (DSC) of the light-receiving side-sealing sheet,
**characterized in that**
the melt peak temperature based on DSC of the light-receiving side-sealing sheet is 75°C or lower, or in a range of substantially no peak observed, and the melt peak temperature based on DSC of the backside-sealing sheet is 90°C or higher, and
wherein the backside-sealing sheet comprises: an ethylene-based polymer obtained by modifying an ethylene·α-olefin copolymer having a density of 900 to 940 kg/m³ as measured in conformity to ASTM D1505 and a melt peak temperature based on DSC of 90 to 125°C with an ethylenic unsaturated silane compound; and a colorant.

2. The pair of solar battery-sealing sheets according to claim 1, wherein a proportion of a constituting unit derived from the ethylene in the ethylene·α-olefin copolymer is 90 to 98 mol%, and a proportion of a constituting unit derived from the α-olefin therein is 2 to 10 mol%.

3. The pair of solar battery-sealing sheets according to claim 1, wherein the light-receiving side-sealing sheet comprises 1) an ethylene-based polymer having a density of 860 kg/m³ or higher and lower than 900 kg/m³ as measured in conformity to ASTM D1505 and a melt peak temperature based on DSC of lower than 75°C, or 2) an ethylene-vinyl acetate copolymer having a vinyl acetate content of 10 to 47% by mass and a melt peak temperature based on DSC of lower than 75°C.

4. The pair of solar battery-sealing sheets according to claim 3, wherein the ethylene-based polymer 1) is an ethylene·α-olefin copolymer satisfying any or all of the following requirements a1) to a4):
a1) a proportion of a constituting unit derived from ethylene is 80 to 90 mol%, and a proportion of a constituting unit derived from an α-olefin having 3 to 20 carbon atoms (for example, propylene, butene and pentene) is 10 to 20 mol%;
a2) a melt flow rate (MFR) measured in conformity to ASTM D1238 under the condition of 190°C and a load of 2.16 kg is 10 to 50 g/10 min;
a3) a density measured in conformity to ASTM D1505 is 0.865 to 0.884 g/cm³; and
a4) a Shore A hardness measured in conformity to ASTM D2240 is 60 to 85.

5. The pair of solar battery-sealing sheets according to claim 3, wherein a melt flow rate (MFR) of the ethylene-vinyl acetate copolymer 2) as measured in conformity to ASTM D1238 under the condition of 190°C and a load of 2.16 kg is 10 to 35 g/10 min.

6. A solar battery module, being obtained by laminating a light-receiving side-protection member, a light-receiving side-sealing sheet, a solar electricity generating element, a backside-sealing sheet, and a backside-protection member in this order,
**characterized in that** the light-receiving side-sealing sheet and the backside-sealing sheet are a light-receiving side-sealing sheet and a backside-sealing sheet of the pair of solar battery-sealing sheets according to any one of claims 1 to 5, respectively.

7. A method for manufacturing a solar battery module, comprising a step of stacking a light-receiving side-protection member, a light-receiving side-sealing sheet, a solar electricity generating element, a backside-sealing sheet, and a backside-protection member in this order, and thermally pressure-bonding the resultant to obtain a laminate,
**characterized in that** the light-receiving side-sealing sheet and the backside-sealing sheet are a light-receiving side-sealing sheet and a backside-sealing sheet of the pair of solar battery-sealing sheets according to any one of claims 1 to 5, respectively.

## Patentansprüche

1. Abdichtungsfolienpaar für eine Solarbatterie, das eine Abdichtungsfolie für die lichtempfangende Seite und eine Rückseitenabdichtungsfolie für ein solarstromerzeugendes Element eines Solarbatteriemoduls umfasst,
wobei eine Schmelzpeaktemperatur, basierend auf dynamischer Differenzkalorimetrie (DSC), der Rückseitenabdichtungsfolie höher als eine Schmelzpeaktemperatur, basierend auf dynamischer Differenzkalorimetrie (DSC), der Abdichtungsfolie für die lichtempfangende Seite ist,
**dadurch gekennzeichnet, dass**
die Schmelzpeaktemperatur, basierend auf DSC, der Abdichtungsfolie für die lichtempfangende Seite 75°C oder niedriger ist oder in einem Bereich liegt, in dem im Wesentlichen kein Peak beobachtet wird, und die Schmelzpeaktemperatur, basierend auf der DSC, der Rückseitenabdichtungsfolie 90°C oder höher ist, und
wobei die Rückseitenabdichtungsfolie umfasst: ein Ethylen-basiertes Polymer, erhalten durch Modifizieren eines Ethylen·α-Olefin-Copolymers mit einer Dichte von 900 bis 940 kg/m³, gemessen in Übereinstimmung mit ASTM D1505, und einer Schmelzpeaktemperatur, basierend auf DSC, von 90 bis 125°C mit einer ethylenisch ungesättigten Silanverbindung; und einen Farbstoff.

2. Abdichtungsfolienpaar für eine Solarbatterie gemäß Anspruch 1, wobei ein Anteil einer von Ethylen stammenden Struktureinheit in dem Ethylen·α-Olefin-Copolymer 90 bis 98 Mol-% beträgt und ein Anteil einer von einem α-Olefin stammenden Struktureinheit darin 2 bis 10 Mol-% beträgt.

3. Abdichtungsfolienpaar für eine Solarbatterie gemäß Anspruch 1, wobei die Abdichtungsfolie für die lichtempfangende Seite 1) ein Ethylen-basiertes Polymer mit einer Dichte, gemessen in Übereinstimmung mit ASTM D1505, von 860 kg/m³ oder höher und niedriger als 900 kg/m³ und einer Schmelzpeaktemperatur, basierend auf DSC, von niedriger als 75°C oder 2) ein Ethylen-Vinylacetat-Copolymer mit einem Vinylacetatgehalt von 10 bis 47 Massen-% und einer Schmelzpeaktemperatur, basierend auf DSC, von niedriger als 75°C umfasst.

4. Abdichtungsfolienpaar für eine Solarbatterie gemäß Anspruch 3, wobei das Ethylen-basierte Polymer 1) ein Ethylen·α-Olefin-Copolymer ist, das irgendwelche oder alle der folgenden Anforderungen a1) bis a4) erfüllt:
a1) ein Anteil einer von Ethylen stammenden Struktureinheit beträgt 80 bis 90 Mol-% und ein Anteil einer von einem α-Olefin mit 3 bis 20 Kohlenstoffatomen stammenden Struktureinheit (zum Beispiel Propylen, Buten und Penten) beträgt 10 zu 20 Mol-%;
a2) eine Schmelzflussrate (MFR), gemessen in Übereinstimmung mit ASTM D1238 unter Bedingungen von 190°C und einer Last von 2,16 kg, beträgt 10 bis 50 g/10 min;
a3) eine Dichte, gemessen in Übereinstimmung mit ASTM D1505, beträgt 0,865 bis 0,884 g/cm³; und
a4) eine Shore-A-Härte, gemessen in Übereinstimmung mit ASTM D2240, beträgt 60 bis 85.

5. Abdichtungsfolienpaar für eine Solarbatterie gemäß Anspruch 3, wobei eine Schmelzflussrate (MFR) des Ethylen-Vinylacetat-Copolymers 2), gemessen in Übereinstimmung mit ASTM D1238 unter Bedingungen von 190°C und einer Last von 2,16 kg, 10 bis 35 g/10 min beträgt.

6. Solarbatteriemodul, erhalten durch Laminieren von einem Schutzelement für die lichtempfangende Seite, einer Abdichtungsfolie für die lichtempfangende Seite, einem solarstromerzeugenden Element, einer Rückseitenabdichtungsfolie und einem Rückseitenschutzelement in dieser Reihenfolge,
**dadurch gekennzeichnet, dass**
die Abdichtungsfolie für die lichtempfangende Seite und die Rückseitenabdichtungsfolie eine Abdichtungsfolie für die lichtempfangende Seite bzw. eine Rückseitenabdichtungsfolie des Abdichtungsfolienpaars für eine Solarbatterie gemäß einem der Ansprüche 1 bis 5 sind.

7. Verfahren zur Herstellung eines Solarbatteriemoduls, umfassend einen Schritt des Stapelns von einem Schutzelement für die lichtempfangende Seite, einer Abdichtungsfolie für die lichtempfangende Seite, einem solarstromerzeugenden Element, einer Rückseitenabdichtungsfolie und einem Rückseitenschutzelement in dieser Reihenfolge und des thermischen Pressverbindens des Resultierenden, um ein Laminat zu erhalten,
**dadurch gekennzeichnet, dass**
die Abdichtungsfolie für die lichtempfangende Seite und die Rückseitenabdichtungsfolie eine Abdichtungsfolie für die lichtempfangende Seite bzw. eine Rückseitenabdichtungsfolie des Abdichtungsfolienpaars für eine Solarbatterie gemäß einem der Ansprüche 1 bis 5 sind.

## Revendications

1. Paire de feuilles d'étanchéité de batterie solaire comprenant une feuille d'étanchéité côté réception de lumière et une feuille d'étanchéité côté arrière pour un élément de génération d'électricité solaire d'un module de batterie solaire,
dans laquelle une température de pic de fusion basée sur une calorimétrie à balayage différentiel (DSC) de la feuille d'étanchéité côté arrière est plus élevée qu'une température de pic de fusion basée sur la calorimétrie à balayage différentiel (DSC) de la feuille d'étanchéité côté réception de lumière,
**caractérisée en ce que**
la température de pic de fusion basée sur la DSC de la feuille d'étanchéité côté réception de lumière est de 75 °C ou moins, ou dans une plage pratiquement sans pic observé, et la température de pic de fusion basée sur la DSC de la feuille d'étanchéité côté arrière est de 90 °C ou plus, et
dans laquelle la feuille d'étanchéité côté arrière comprend : un polymère à base d'éthylène obtenu en modifiant un copolymère d'éthylène·α-oléfine ayant une densité de 900 à 940 kg/m³ telle que mesurée conformément à la norme ASTM D1505 et à une température de pic de fusion basée sur une DSC de 90 à 125 °C avec un composé de silane insaturé éthylénique ; et un colorant.

2. Paire de feuilles d'étanchéité de batterie solaire selon la revendication 1, dans laquelle une proportion d'une unité constituante dérivée de l'éthylène dans le copolymère d'éthylène·α-oléfine est de 90 à 98 % en mole, et une proportion d'une unité constituante dérivée de la α-oléfine dans celui-ci est de 2 à 10 % en mole.

3. Paire de feuilles d'étanchéité de batterie solaire selon la revendication 1, dans laquelle la feuille d'étanchéité côté réception de lumière comprend 1) un polymère à base d'éthylène ayant une densité de 860 kg/m³ ou plus et inférieure à 900 kg/m³ telle que mesurée conformément à la norme ASTM D1505 et à une température de pic de fusion basée sur une DSC de 75 °C, ou 2) un copolymère d'éthylène-acétate de vinyle ayant une teneur en acétate de vinyle de 10 à 47 % en masse et une température de pic de fusion basée sur une DSC inférieure à 75 °C.

4. Paire de feuilles d'étanchéité de batterie solaire selon la revendication 3, dans laquelle le polymère à base d'éthylène 1) est un copolymère d'éthylène·α-oléfine satisfaisant l'une quelconque ou la totalité des exigences suivantes a1) à a4) :
a1) une proportion d'une unité constituante dérivée de l'éthylène est de 80 à 90 % en mole, et une proportion d'une unité constituante dérivée d'une α-oléfine ayant de 3 à 20 atomes de carbones (par exemple, propylène, butène et pentène) est de 10 à 20 % en mole ;
a2) une vitesse d'écoulement à l'état fondu (MFR) mesurée conformément à la norme ASTM D1238 sous la condition de 190 °C et d'une charge de 2,16 kg est de 10 à 50 g/10 min ;
a3) une densité mesurée conformément à la norme ASTM D1505 est de 0,865 à 0,884 g/cm³ ; et
a4) une dureté Shore A mesurée conformément à la norme ASTM D2240 est de 60 à 85.

5. Paire de feuilles d'étanchéité de batterie solaire selon la revendication 3, dans laquelle une vitesse d'écoulement à l'état fondu (MFR) du copolymère d'éthylène-acétate de vinyle 2) telle que mesurée conformément à la norme ASTM D1238 sous la condition de 190 °C et d'une charge de 2,16 kg est de 10 à 35 g/10 min.

6. Module de batterie solaire, étant obtenu en stratifiant un élément de protection côté réception de lumière, une feuille d'étanchéité côté réception de lumière, un élément de génération d'électricité solaire, une feuille d'étanchéité côté arrière et un élément de protection côté arrière dans cet ordre,
**caractérisé en ce que** la feuille d'étanchéité côté réception de lumière et la feuille d'étanchéité côté arrière sont respectivement une feuille d'étanchéité côté réception de lumière et une feuille d'étanchéité côté arrière de la paire de feuilles d'étanchéité de batterie solaire selon l'une quelconque des revendications 1 à 5.

7. Procédé de fabrication d'un module de batterie solaire, comprenant une étape d'empilement d'un élément de protection côté réception de lumière, d'une feuille d'étanchéité côté réception de lumière, d'un élément de génération d'électricité solaire, d'une feuille d'étanchéité côté arrière et d'un élément de protection côté arrière dans cet ordre, et de liaison par pression thermique du produit résultant afin d'obtenir un stratifié,
**caractérisé en ce que** la feuille d'étanchéité côté réception de lumière et la feuille d'étanchéité côté arrière sont respectivement une feuille d'étanchéité côté réception de lumière et une feuille d'étanchéité côté arrière de la paire de feuilles d'étanchéité de batterie solaire selon l'une quelconque des revendications 1 à 5.
